# EUROPEAN PATENT APPLICATION

(11) **EP 0 853 375 A1**
(43) Date of publication of application: **15.07.1998**
(21) Application number: 97310153.8
(22) Date of filing: 16.12.1997
(51) Int. Cl.: H03D 7/14

(54) **Double balanced mixer circuit**

(30) Priority: 10.01.1997 GB 9700439
(71) Applicant: PLESSEY SEMICONDUCTORS LIMITED, Swindon, Wiltshire SN2 2QW (GB)
(72) Inventor: Stanton, James Christopher, Swindon, Wiltshire, SN1 3NZ (GB)
(74) Representative: Hoste, Colin Francis

(57) **Abstract**

Mixer circuit 400 receives a differential input voltage signal on terminals 440, 441. The input voltage signal is converted into a differential current signal by current conveyors 420, 421, the circuits of which are shown in Figures 2 and 3. Current conveyors 420, 421 each operate to hold the voltage at current input X equal to the voltage present on voltage input Y. By virtue of resistors 411, 413, the Y terminals of current conveyors 420, 421 each receive the common mode voltage of the input signal. This causes the current signal at the X terminals to have a zero bias and to vary linearly with the input voltage. The current output from Z is dependent on the input current at X thus mixer core 430 receives differential current signals representative of the input voltage signal. Because the voltage at the Z terminals of current conveyors 420, 421 is independent of the input voltage, this circuit is particularly useful in low voltage applications.

## Description

The present invention relates to mixer circuit arrangements and in particular, though not exclusively, to mixer circuit arrangements that can be used in low voltage applications.

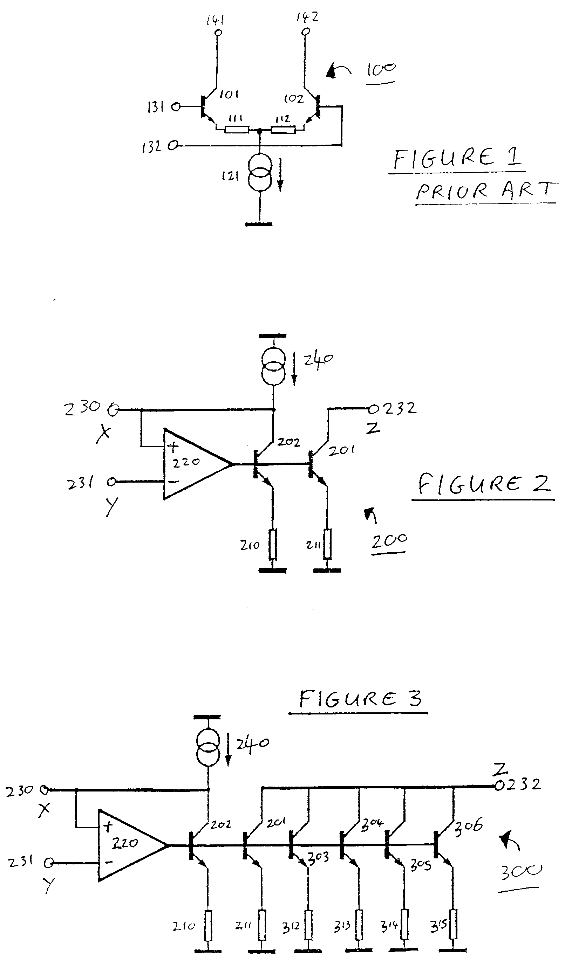

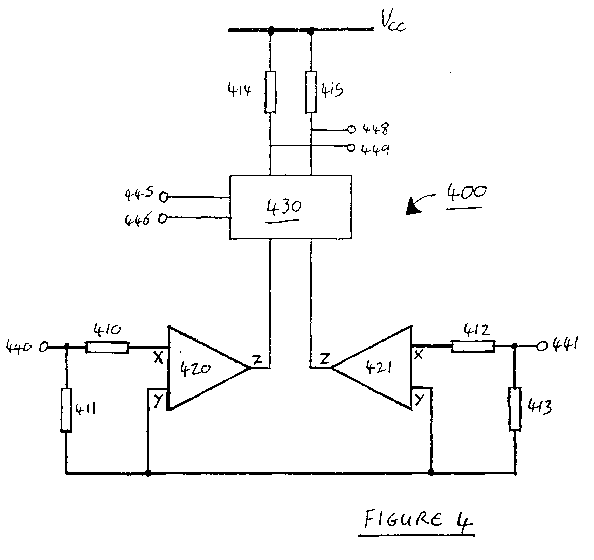

Double-balanced mixers that use the standard four transistor mixer core usually require a voltage to current convertor to convert a differential input signal voltage to a differential current signal. This conversion is often carried out by an emitter coupled pair of transistors with emitter degeneration resistors, an example of which is shown in the mixer circuit of Figure 1.

Referring to Figure 1, mixer circuit 100 comprises npn transistors 101, 102 which provide differential output current signals on their collectors, in response to input voltage signals, to a mixer core, formed by transistors 103 - 106. Current source 121 allows complementary currents to he provided on each differential output.

Although such voltage to current convertors offer reasonable linearity and a balanced output, it has been found that they are unsuitable for use in certain low voltage applications where the input signals are relatively large.

Thus, with a differential input signal having a swing of 1.1 volts the base electrodes of transistors 101, 102 would need to be biased at a common mode voltage of 1.2 volts or more to ensure that transistors 101 and 102 remained switched on. This in turn would require the collectors to be biased
at a relatively high level to attain acceptably low levels of distortion of the output signal. It has been found that for minimum distortion of the output signal when the collectors of transistors 101, 102 are biased at 1.5 volts, in response to an input signal swing of 1.1 volts, a common mode bias voltage of 1.6 volts is required. Larger input signals could only be accommodated without increased distortion by increasing the common mode voltage of the input signal and further increasing the collector bias.

Increased collector voltage resulted in a larger proportion of the supply voltage being, in effect, unavailable for use by the circuitry to which the output signal of the Figure 1 circuit is provided. For correct operation of this circuitry, generally a mixer core and load resistors, it may even be necessary to increase the supply voltage. This may also be necessary if, for example, the input signal had a particularly high common mode voltage. In accordance with the present invention there is provided a mixer circuit arrangement comprising a mixer core, means to convert a differential input voltage signal into a differential current signal and first and second current conveyors arranged to provide the mixer core with first and second current signals representative of the differential current signal.

An embodiment of the present invention will now he described by way of example with reference to the accompanying drawings of which;
Figure 1 shows a prior art differential voltage to differential current convertor;
Figure 2 shows a current conveyor circuit suitable for use in a mixer circuit arrangement in accordance with the present invention;
Figure 3 shows a further current conveyor circuit, and
Figure 4 shows a double balanced mixer circuit in accordance with the present invention.

Referring first to Figure 2, current conveyor circuit 200 comprises op-amp 220, current source 240, transistors 201 and 202, resistors 210 and 211, input terminals 230 and 231 and output terminal 232.

Input terminal 230 is connected to the non-inverting input of op-amp 220, to the negative terminal of current source 240 and to the collector electrode of transistor 202. The positive terminal of current source 240 is connected to supply voltage. Input terminal 231 is connected to the inverting input of op-amp 220. The output of op-amp 220 is connected to the base electrodes of both transistors 201 and 202. Output terminal 232 is connected to the collector electrode of transistor 201. Resistors 210 and 211 are connected between ground potential and the emitter electrodes of transistors 202 and 201 respectively.

Resistors 210 and 211 provide series negative feedback in the base-emitter circuits of transistors 202 and 201 respectively, which improves the noise properties of current conveyor circuit 200 but reduces its signal handling capability. The current conveyor circuit 200 could be implemented without resistors 210 and 211.

The output current is obtained by using the base voltage of transistor 202 to control a collector current in output transistor 201. Current gain can be obtained by providing current conveyor circuit 200 with more output transistors. Such a modified circuit is shown in Figure 3.

Figure 3 shows a current conveyor circuit 300 comprising all the components of the Figure 2 circuit, to which the same reference numerals have been applied, together with transistors 303 - 306 and resistors 312-315. Each of the transistors 303 - 306 has its base electrode connected in common to the output of op-amp 220 and its collector electrode connected in common to output terminal 232. Resistors 312, 313, 314 and 315 connect the emitter electrodes of transistors 303, 304, 305 and 306 respectively to ground potential.

The effect of transistors 303 - 306 is to provide current gain but this could be achieved simply by forming transistor 201 of Figure 2 with a larger emitter area than transistor 202 and by replacing resistor 211 with one having a smaller value (inversely proportional to the ratio of the emitter areas of transistors 201 and 202). The Figure 3 circuit will have more linear characteristics, provided transistors 201, 202 and 303 - 306 are matched, than the case where a single, large output transistor 201 is used. Also, a higher overall loop gain of current conveyor 300, predominantly defined by the open loop gain of op-amp 220, will result in improved linearity.

Both the Figure 2 and Figure 3 current conveyor circuits are labelled as three terminal networks. Each could be referred to as an indirect-feedback current source with a current follower input. Input terminal 231 is a high impedance voltage input and is labelled Y. Input terminal 230 is a low impedance current input and is labelled X. Output terminal 232 is labelled Z and is a current output terminal. The output current from terminal Z is generally proportional to the input current received at terminal X even though the voltage at these terminals may be different, hence the term "current conveyor". In current conveyor circuits 200 and 300, the voltage applied to terminal Y defines the voltage at which terminal X is held. The voltage at terminal X will match the voltage of terminal Y except for a small (error) voltage difference. This error voltage can be minimised by maximising the gain of op-amp 220.

Current conveyor circuits such as those shown in Figures 2 and 3 offer particular advantages in double balanced mixer circuits where the input signal is a differential voltage signal, especially where the common mode voltage of the input signal is not defined or is relatively high.

Referring now to Figure 4, a double balanced mixer circuit 400 in accordance with the present invention is shown comprising input terminals 440, 441, resistors 410 - 415, mixer core 430, local oscillator input terminals 445, 446, current conveyors 420, 421 and output terminals 448, 449.

Resistor 410 connects input terminal 440 to the X terminal of current conveyor 420. Resistor 412 connects input terminal 441 to the X terminal of current conveyor 421. Resistors 411 and 413 are connected in series between input terminals 440 and 441 with the Y terminals of current conveyors 420, 421 being connected to the common node of these resistors 411, 413. The Z terminals of current conveyors 420, 421 are connected respectively to first and second signal inputs of mixer core 430. Local oscillator input terminals 445, 446 are connected to first and second control inputs respectively of mixer core 430. Load resistors 414 and 415 connect first and second outputs of mixer core 430 respectively to supply voltage. Output terminals 449, 448 are connected also to the first and second outputs respectively of mixer core 430.

In use, a differential voltage signal is applied to input terminals 440 and 441. If resistors 411 and 413 have the same value of resistance, the voltage resulting at terminal Y on both current conveyors 420, 421 will be equal to the common mode voltage of the input signal. Current conveyors 420, 421 will each cause the voltage at their respective X terminals to be at or close to the common mode voltage of the input signal. In this way, the dc voltage across resistors 410 and 412 is kept at zero volts and consequently the input bias current is nominally zero. The current received at terminal X of current conveyor 420 will thus be representative of the differential voltage applied to input terminals 440, 441 and of the same magnitude but of opposite sign to the current received at node X of current conveyor 421.

The resulting current signals provided by current conveyors 420, 421 from their Z terminals are fed to mixer core 430 where they are mixed with a local oscillator signal which is applied to local oscillator terminals 445, 446. The resulting differential output signal is seen at output terminals 448, 449 as a voltage signal by virtue of resistors 414 and 415.

It will be appreciated that other forms of mixer core may be utilised but it is preferred that a mixer core is used that will require the minimum amount of voltage headroom, to take full advantage of the headroom saved by the implementation of current conveyors 420, 421.

It has been found that input signals having relatively large voltage swings about a low common mode voltage are effectively handled by the Figure 4 mixer circuit with low levels of distortion, even with the Z terminals of current conveyors 420, 421 being biased to only a few hundred milli-volts.

Although the embodiments have been described solely with regard to npn bipolar transistors it will be clear that either of pnp bipolar transistors and field effect transistors could be substituted with only minor, if any, modification to the remaining circuit arrangement.

## Claims

1. A mixer circuit arrangement comprising a mixer core, means to convert a differential input voltage signal into a differential current signal and first and second current conveyors arranged to provide the mixer core with first and second current signals representative of the differential current signal.

2. A mixer circuit arrangement in accordance with Claim 1 in which the first and second current conveyors provide the first and second current signals at a voltage which is independent of the input signal voltage.

3. A mixer circuit arrangement in accordance with Claim 2 in which the first and second current conveyors provide the first and second current signals at a low voltage.

4. A mixer circuit arrangement in accordance with any preceding claim in which the current conveyors each comprise an indirect-feedback current source with a current follower input.

5. A mixer circuit arrangement in accordance with any one of Claims 1 to 3 in which each of the current conveyors has first and second input terminals and an output terminal, a differential amplifier to respective first and second inputs of which the first and second input terminals are connected, and feedback means arranged to maintain the voltage at the second input terminal at or close to the voltage on the first input terminal.

6. A mixer circuit arrangement in accordance with Claim 5 in which the first input terminal of each current conveyor is arranged to receive a signal representative of the common mode voltage of the input signal.

7. A mixer circuit arrangement in accordance with Claim 6 in which the input signal is received on first and second input terminals of the mixer circuit arrangement having a resistor network connected between them and the respective first input terminals of the current conveyor circuits are connected to an intermediate node of the resistor network thereby to provide the signal representative of the common mode voltage of the input signal.

8. A mixer circuit arrangement in accordance with Claim 7 in which the input signal is converted into a differential current signal by way of respective input resistors connected between the respective input terminals of the mixer circuit arrangement and the second inputs of the respective differential amplifiers of the first and second current conveyors.

9. A mixer arrangement in accordance with any preceding claim in which the mixer core is arranged to mix the first and second current signals with a differential signal from a local oscillator.
